# EUROPEAN PATENT APPLICATION

(11) **EP 4 822 997 A1**
(43) Date of publication of application: **14.10.2026**
(21) Application number: 25168941.0
(22) Date of filing: 07.04.2025
(51) Int. Cl.: H03M 13/37, H03M 13/45, H03M 13/00, H04L 1/00, H03M 13/25

(54) **APPARATUS, METHOD AND COMPUTER PROGRAM FOR DECODING A RECEIVED CODEWORD**

(71) Applicant: Technische Universität München, in Vertretung des Freistaates Bayern, 80333 München (DE)
(72) Inventor: VOICHTLEITNER, Johannes, 84416 Taufkirchen (DE); WIESE, Moritz, 80333 München (DE); BOCHE, Holger, 10318 Berlin (DE)
(74) Representative: 2SPL Patentanwälte PartG mbB

(57) **Abstract**

Provided is a method, an apparatus, and a computer program for decoding a received codeword. The method (10) for decoding a received codeword, which is based on an encoded original codeword, comprises obtaining (12) the received codeword as soft decoded bits, a maximum error order and a limit value. The method (10) further comprises generating (14) a queue of codeword candidates. The codeword candidates are based on the maximum error order, the limit and a sorted codeword, which is based on the received codeword. The sorted codeword comprises sorted soft decoded bits, which are sorted based on their soft values and based on a systematic code mapping. The method (10) further comprises decoding (16) the codeword candidates of the queue to determine a most likely codeword candidate and selecting (18) the most likely codeword candidate as decoded original codeword.

## Description

### Field

The present disclosure relates to a method, an apparatus, and a computer program for decoding a received codeword, more particularly, but not exclusively, to a decoding concept considering a limited number of potential error vectors of different orders.

### Background

Decoders in communication systems are critical for accurately reconstructing the transmitted information in the presence of noise, interference, and other impairments that occur during signal propagation. They serve as the final stage in the receiver chain, where the received signals (often in the form of soft or hard bits) are processed to retrieve the original data. Advances in coding theory and signal processing techniques have led to sophisticated decoders - such as convolutional decoders, Turbo decoders, and LDPC (Low Density Parity Check) decoders - that minimize the probability of error within practical constraints on power, bandwidth, and complexity. For example, decoders are designed to contend with the dynamic and challenging environment of wireless links, ensuring robustness and reliability of transmission in both low- and high-data-rate applications.

A key performance benchmark for decoders is maximum likelihood (ML) decoding, at least in cases in which all codewords occur with the same likelihood, otherwise maximum a posteriori decoding may be the benchmark. ML decoding seeks to find the codeword in a given codebook that has the highest probability of having been transmitted, given the received signal. ML decoding is theoretically optimal, maximizing the likelihood of correct decoding. However, implementing ML decoding directly can be exceedingly complex, especially for large block sizes because the number of possible codewords often grows exponentially with the length of the code. Practical implementations employ various algorithmic strategies - like the Viterbi algorithm for convolutional codes or sphere decoding for certain block codes - to approximate or efficiently realize ML decoding. Nonetheless, even these more efficient techniques can demand considerable computational resources and power consumption, posing significant challenges in hardware-constrained mobile devices.

Beyond maximum likelihood approaches, especially mobile communication systems use various decoding algorithms to balance decoding performance with hardware and latency considerations. Convolutional decoders, Turbo decoders, and LDPC decoders each have unique advantages, often traded off against their respective complexities. Implementing them on modern mobile platforms requires thoughtful consideration of processing latency, since faster decoders can reduce end-to-end communication delays but might also consume more power or compromise accuracy. Striking the right compromise between speed and correctness is a central challenge: systems must be designed to handle the rigors of real-time operation in diverse conditions while avoiding the prohibitive computational overhead of ideal decoding methods. As a result, mobile communication standards typically include guidelines and optimizations that enable efficient decoders to handle high data rates and complex signal environments without exhausting device resources or introducing excessive delay.

Further details can be found in the following references, to which it will also be referred subsequently:

### References:

[1] H. Van Tilborg, R. McEliece, and E. Berlekamp, "On the inherent intractability of certain coding problems," 1978;
[2] M. P. Fossorier and S. Lin, "Soft-decision decoding of linear block codes based on ordered statistics," IEEE Transactions on Information Theory, vol. 41, no. 5, pp. 1379-1396, 1995;
[3] K. R. Duffy, J. Li, and M. M'edard, "Capacity-achieving guessing random additive noise decoding," IEEE Transactions on Information Theory, vol. 65, no. 7, pp. 4023-4040, 2019;
[4] A. Solomon, K. R. Duffy, and M. M'edard, "Soft maximum likelihood decoding using grand," in ICC 2020 - 2020 IEEE International Conference on Communications (ICC), 2020, pp. 1-6;
[5] K. R. Duffy, W. An, and M. M'edard, "Ordered reliability bits guessing random additive noise decoding," IEEE Transactions on Signal Processing, vol. 70, pp. 4528-4542, 2022; and
[6] R. H. Morelos-Zaragoza, The art of error correcting coding. John Wiley & Sons, 2006.

### Summary

Examples of the present disclosure are based on the finding that a tradeoff between decoding performance and decoding latency can be found by considering error vectors of different orders and limiting a number of error vectors considered during decoding by comparing likelihoods of error vectors of different orders.

Examples provide a method for decoding a received codeword, which is based on an encoded original codeword. The method comprises obtaining the received codeword as soft decoded bits, a maximum error order and a limit value. The method further includes generating a queue of codeword candidates. The codeword candidates are based on the maximum error order, the limit and a sorted codeword, which is based on the received codeword. The sorted codeword comprises sorted soft decoded bits, which are sorted based on their soft values and based on a systematic code mapping. The method further comprises decoding the codeword candidates of the queue to determine a most likely codeword candidate and selecting the most likely codeword candidate as decoded original codeword. Therewith, a high decoding performance can be obtained at reasonable complexity.

In further examples, the generating may further comprise determining a first mapping as part of the systematic code mapping between the order of the received codeword and a sorted received codeword. Hence, the first mapping reorders the received codeword into a sorted received codeword. The sorted received codeword being sorted based on the soft values of the soft decoded bits. The first mapping is applied to a generator matrix of a code of the received codeword to obtain a mapped generator matrix. Sorting the bits of the received codeword may enable systematic decoding and error consideration based on a confidentiality of the respective bits. The method may further comprise determining a second mapping as part of the systematic code mapping. The second mapping transforming the mapped generator matrix to a systematic generator matrix. The determining of the second mapping is based on the mapped generator matrix and the generating comprises applying the first and second mappings to the received codeword to obtain the sorted codeword. Thereby a systematic and sorted representation can be obtained, which enables efficient processing.

The decoding may comprise hard-decoding the sorted codeword to obtain a hard-decoded codeword and re-encoding the hard-decoded codeword to obtain a generated codeword. The decoding may further comprise determining a metric for the generated codeword indicating a likelihood of the generated codeword in view of the sorted codeword and storing the generated codeword together with the metric as candidate codeword in the queue. This process may enable an efficient build-up of the queue for later candidate selection. For example, the metric may correspond to a sum of the absolute soft values of the bits of the sorted codeword, which divert from the generated codeword, and/or the metric may correspond to a Euclidean distance of a modulated generated codeword and the received codeword. These are two options for efficiently determining a metric that allows evaluating codeword candidates against each other.

Furthermore, the decoding may comprise defining a set or a queue of multiple error vectors. An error vector comprises one or more error digits based on the maximum error order and the set/queue of error vectors comprises an error vector of each order from one to the maximum order. An error vector of a specific order is determined by iterating through error vectors of the specific order. The number of error vectors is limited by the limit value and a likeliness of an error vector is determined based on the soft values of the sorted codeword at the error positions. Thereby, an efficient set/queue of error vectors can be generated. The iterating may comprise systematically iterating through error positions in the error vector of the specific order. For example, the systematically iterating starts at the most likely error positions and ends at the most unlikely error positions. That way, the generation of the error vector set/queue may not only be efficient it may also consider error vectors which cover the most likely error occurrences in the sorted codeword.

At least in some examples the method may further include assigning an error metric to each of the error vectors. The metric is based on the sorted codeword. The metric may be similar as the above metric for the codeword candidates and may be based on the potential erroneous soft bits as indicated by the respective error vector. Again, the metric may form an efficient basis for evaluating the error vectors against each other and select the most promising ones for being considered in a limited set of error vectors for decoding.

For example, the decoding comprises, when iterating through the error vectors, flipping bits in the hard-decoded codeword at positions at which the corresponding error vector indicates an error in the hard-decoded codeword to obtain a new codeword candidate. The new codeword candidate is then re-encoded to obtain a generated candidate codeword, and a metric is determined for the candidate codeword. Hence, the candidate codewords are then based on the potential erroneous digits as indicated by the error vectors, which are selected to find the most promising candidate codewords. Again, the metric may correspond to a sum of the absolute soft values of the bits of the sorted codeword, which divert from the generated candidate codeword. Additionally or alternatively, the metric may correspond to an Euclidean distance of a modulated generated candidate codeword and the received codeword.

The method may further comprise storing the error-corrected codewords or the generated candidate codewords together with the metrics in the queue. Thereby, examples enable an effective evaluation of the candidate codewords among each other. The decoding may further comprise inversely mapping the codewords of the queue based on the systematic code mapping to obtain a queue of de-mapped codewords. The decoding may further include modulating the de-mapped codewords of the queue to obtain a queue of modulated codewords and using maximum likelihood decoding of the modulated de-mapped codewords of the queue to obtain the most likely codeword candidate. Examples may enable maximum likelihood decoding of the de-mapped codewords in the queue to find the decoded selected codeword with a high probability.

At least in some examples, the method further comprises obtaining a queue limit for the queue of codewords and limiting the size of the queue of codewords based on the queue limit. For example, if the queue reaches the queue limit a most unlikely candidate codeword is removed from the queue. Thereby, the queue size to which maximum likelihood decoding is applied can be limited, which keeps the subsequent decoding complexity reasonable.

Examples further provide a computer program having a program code for performing one of the methods described herein, when the computer program is executed on a computer, a processor, or a programmable hardware component. Examples also provide an apparatus for decoding a received codeword, which is based on an encoded original codeword. The apparatus comprises one or more interfaces configured to communicate in a decoding system and one or more processing devices configured to perform one of the methods described herein. Another example is a decoder or a decoding system comprising an example of the apparatus.

### Brief description of the Figures

Some examples of apparatuses and/or methods will be described in the following by way of example only, and with reference to the accompanying figures, in which
Fig. 1 shows a block diagram of a flow chart of an example of a method for decoding a received codeword;
Fig. 2 illustrates a block diagram of an example of an apparatus for decoding a received codeword;
Fig. 3 depicts a general transmission model;
Fig. 4 shows a chart of BLER versus Eb/NO in a comparison of ORBGRAND and OSD;
Fig. 5 illustrates a chart of DER versus Eb/NO for different queries at the top and a chart of BLER versus Eb/NO for different orders at the bottom;
Fig. 6 depicts a chart of BLER versus Eb/NO for different decoders at the top and a chart of BLER versus Eb/NO for different queries at the bottom; and
Fig. 7 shows a chart of BLER versus Eb/NO for different orders and decoders.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

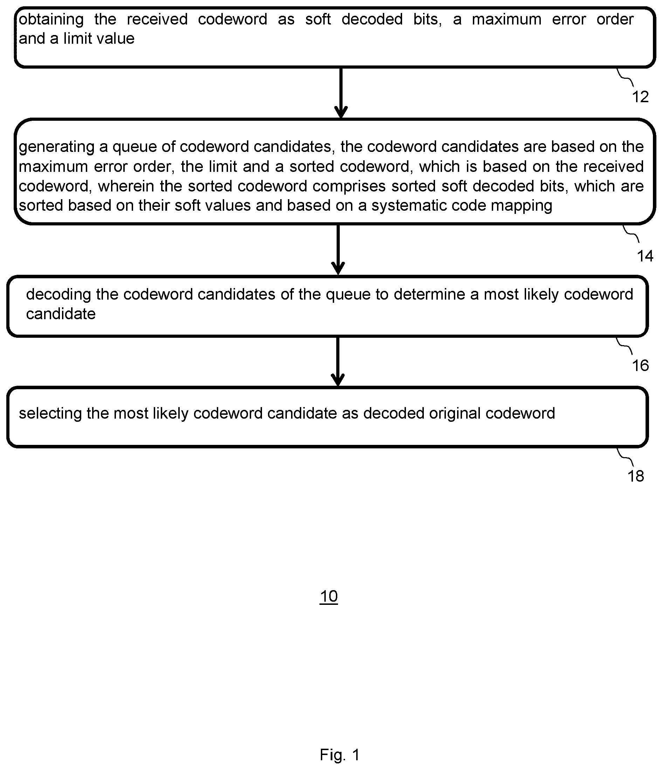

Fig. 1 shows a block diagram of a flow chart of an example of a method 10 for decoding a received codeword. The received codeword is based on an encoded original codeword. The method 10 comprises obtaining 12 the received codeword as soft decoded bits, obtaining 12 a maximum error order and obtaining 12 a limit value. The method 10 further includes generating 14 a queue of codeword candidates. The codeword candidates are based on the maximum error order, the limit and a sorted codeword. The sorted codeword is based on the received codeword. The sorted codeword comprises sorted soft decoded bits, which are sorted based on their soft values and which are based on a systematic code mapping. The method 10 further comprises decoding 16 the codeword candidates of the queue to determine a most likely codeword candidate and selecting 18 the most likely codeword candidate as decoded original codeword.

Soft bits are a crucial concept in modern digital communications, particularly in the context of channel coding and decoding. Unlike hard bits, which are strict binary decisions (0 or 1), soft bits represent the probability or confidence level of each bit being a 0 or a 1. This probabilistic information allows decoders, such as those used in Turbo or LDPC codes, to make more informed decisions and significantly improve error correction performance. Soft bits are especially valuable in scenarios with high noise or interference, where rigid binary decisions might lead to more frequent decoding errors. They essentially carry "soft" information about the likelihood of each bit's true value based on the received signal and channel characteristics.

There are several methods to derive soft bits from the received signal or received codeword. One widely used approach is calculating the log-likelihood ratio (LLR), which is the logarithm of the ratio of the probabilities of the bit being a 1 to it being a 0, conditioned on the received signal. Higher absolute LLR values correspond to greater confidence in the bit decision. Other options include computing the raw probabilities without taking the logarithm, resulting in direct likelihoods rather than log-likelihoods. Alternatively, soft bits can be extracted based on metrics like Euclidean distances in modulation schemes (e.g., QAM (Quadrature Amplitude Modulation)), where the proximity of the received symbol to ideal constellation points provides an indication of bit reliability. These soft metrics can then be normalized and passed to the decoder, enabling it to exploit the extra information during the iterative decoding process.

Error vector orders (EVOs) play an important role in analyzing the performance and structure of error-correcting codes, particularly in the context of decoding algorithms and code design. An error vector order refers to the number of positions in a codeword where errors have occurred - essentially, the weight of the error vector. Understanding the distribution and likelihood of different error vector orders helps in evaluating a code's error-correcting capability and its robustness under various channel conditions. For example, low-weight error vectors are more probable in channels with low noise levels, and effective codes are designed to detect and correct these efficiently. In iterative decoding schemes, knowledge of the EVOs can also guide the optimization of decoding thresholds and influence the convergence behavior of the algorithm. Moreover, analyzing EVO patterns aids in estimating the code's minimum distance, which is a critical parameter in determining the maximum number of correctable errors. Examples of the present disclosure may limit the number of error vectors considered absolutely, and also per error vector order, as will be outlined in more detail subsequently.

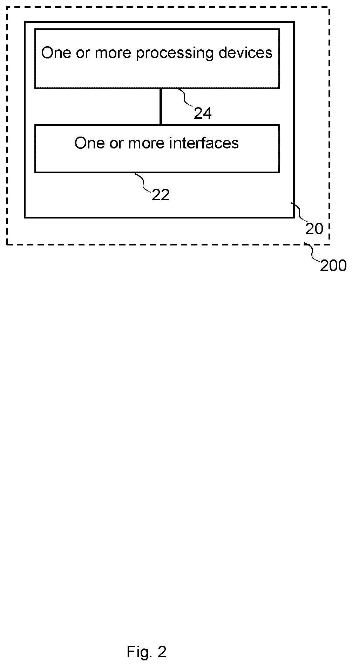

Fig. 2 illustrates a block diagram of an example of an apparatus 20 for decoding a received codeword. The apparatus comprises one or more interfaces 22 configured to communicate in a decoding system and one or more processing devices 24 configured to perform one of the methods 10 as described herein. Another example is a decoder 200 comprising an example of the apparatus 20. The decoder 200 is shown in dashed lines as it is optional form the perspective of the apparatus 20.

As illustrated in Fig. 2, the respective one or more processing devices 24 are coupled to the one or more interfaces 22. The one or more interfaces 22 may correspond and/or be associated to one or more inputs and/or outputs for receiving and/or transmitting information, which may be in digital (bit) values according to a specified code or protocol, within a module, between modules or between modules of different entities. For example, an interface 22 may comprise interface circuitry configured to receive and/or transmit information with respect to the received codeword and/or the decoded original codeword. In examples an interface 22 may correspond to any means for obtaining, receiving, transmitting or providing analog or digital signals or information, e.g., any connector, contact, pin, register, input port, output port, conductor, lane, logical endpoint, etc., as well as any abstraction thereof. An interface 22 may be configured to communicate (transmit, receive, or both) in a wireless or wireline manner and it may be configured to communicate, i.e., transmit and/or receive signals, information with further internal or external components. The one or more interfaces 22 may comprise further components to enable communication in a (mobile) communication/decoding system or network, such components may include transceiver (transmitter and/or receiver) components, such as one or more Low-Noise Amplifiers (LNAs), one or more Power-Amplifiers (PAs), one or more duplexers, one or more diplexers, one or more filters or filter circuitry, one or more converters, one or more mixers, accordingly adapted radio frequency components, etc. Moreover, the one or more interfaces may be APIs (Application Programming Interfaces) in some examples. Moreover, the one or more interfaces may be logical transmission channels within a processing device or between processing devices, especially a signaling channel.

The one or more processing devices 24 may be implemented using one or more processing units, one or more circuitries, any means for processing, such as a processor, a computer or a programmable hardware component being operable with accordingly adapted software. In other words, the described function of the one or more processing devices 24 may as well be implemented in software, which is then executed on one or more programmable hardware components. Such hardware components may comprise a general-purpose processor, a Digital Signal Processor (DSP), a micro-controller, etc. and/or an abstraction thereof.

Decoding systems are essential components in digital communication and coding theory, responsible for interpreting received signals and reconstructing the original transmitted data as accurately as possible. These systems leverage knowledge of the coding scheme and at least some of them also leverage the characteristics of the communication channel to mitigate the effects of noise, interference, or distortion. There are various types of decoding strategies, ranging from simple hard-decision decoders, which operate solely on binary inputs, to more sophisticated soft-decision decoders that utilize probabilistic information to improve error correction performance. Popular decoding algorithms include Viterbi decoding for convolutional codes, belief propagation for LDPC codes, and iterative decoding for Turbo codes, each optimized for specific code structures and channel models. The choice of decoding system has a significant impact on the overall reliability, complexity, and latency of the communication system, balancing trade-offs between computational resources and desired error performance.

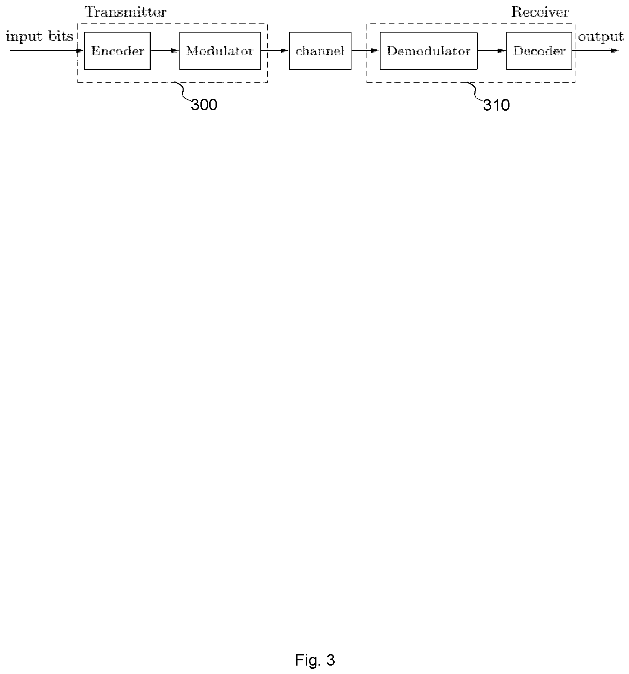

Decoding systems are often applied in communications. Basically, communications engineering deals with the transmission of information from a transmitter to a receiver. A general model of a transmission system is shown in Fig. 3. Fig. 3 depicts a general transmission model. Input bits are input into a transmitter 300, which uses an encoder to encode the input bits and a modulator to modulate the encoded bits for transmission over a communication channel to a receiver 310. The receiver 310 uses a demodulator to demodulate the received signal. A decoder is then used to decode the demodulated signal to obtain the output (bits). The transmission channel is a physical transmission medium between the transmitter 300 and receiver 310. This can be a terrestrial or satellite-based radio link, an optical fiber or a storage medium such as a CD (compact disc).

Since each transmission from the transmitter to the receiver generates noise in the information sent, errors occur in the information received by the receiver. To make the transmission more robust against noise, more bits are sent than the information bits and an error-correcting code is used. As the name error-correcting code suggests, errors induced by the transmission channel can be corrected. This results in fewer errors in the information bits received at the receiver.

An error-correcting code consists of an encoder at the transmitter and a decoder at the receiver. Technically, the encoder maps K bits of information to an N-bit codeword, where N > K. Before transmission into the channel, the codeword to be transmitted is mapped to complex symbols using modulation and after the channel, the channel output is soft demodulated in likelihoods or hard demodulated in bits. In the case of hard demodulation, each received symbol is converted directly into the next closest bit pattern, whereas in the case of soft demodulation, the likelihood for each decision is also taken into account in addition to each bit decision. The decoder then maps the demodulated channel output to K information bits. The likelihood provides the decoder with additional information and is expressed, for example, as a log-likelihood ratio. Note that the demodulated channel output is most likely not a codeword.

There are decoders that are optimized for a specific error-correcting code, but there are also decoders that are used more generally and have been specially developed for universal applicability. It is generally known that the maximum likelihood (ML) decoder is the best error-correcting decoder, which can additionally be used with any linear error-correcting codes. All other existing decoders and those developed in the future will at best achieve error correction like the ML decoder.

The reason why this ML decoder is not applied as a decoder in practice is that ML decoding of arbitrary linear codes is an NP-complete problem [1]. This implies that decoding with an ML decoder, based on the current state of knowledge, is not efficiently solvable and requires a high computing time on real computers.

Instead of looking for a universal and codebook-independent decoder, in practice error-correcting codes are usually developed together with a decoder suitable for this code. In the following examples of a universal and codebook-independent decoder will be described.

In practice, error-correcting codes are usually co-designed with a decoder suitable for this code. However, since examples relate to a universal decoder, the performance of examples are compared with universal decoders. Examples of this include the Ordered Statistics Decoders (OSD) [2] or all decoders of the Guessing Random Additive Noise Decoding (GRAND) family [3, 4, 5]. The following is a rough description of how these decoders work. An OSD decoder sorts and rearranges the soft demodulated input and the generator matrix G in such a way that a systematic generator matrix Gsys can be generated and has a rearranged input which has the likelihoods arranged in a descending order. It is now utilized that a codeword, which is generated with the systematic generator matrix Gsys, can be mapped bijectively to a codeword, which is generated with the normal generator matrix G.

After the systematic generator matrix has been generated and the input has been re-sorted, the decoder can use the first hard demodulated K bits of the re-sorted input to generate a new codeword, because these are equivalent to the K information bits in a systematic generator matrix. A metric for the new codeword is then calculated. This metric can be, for example, the Hamming distance to the hard demodulated input or the Euclidean distance to the received I/Q samples.

Depending on the order of the OSD decoder, error vectors are now added to the first K bits of the hard demodulated and reordered input. If the order is 2, for example, all possible error vectors with a maximum of 2 bits are used. The metric is calculated for each calculated codeword and the calculated codeword with the lowest metric is retained.

After all error vectors have been tested, the resulting codeword is mapped into the row space of the generator matrix G and, if successful, the error-corrected transmitted codeword is obtained.

The GRAND decoder aims to identify the noise effect that has affected the received data. The algorithm is based on the principle that the receiver ranks the noise sequences from the most probable to the least probable and estimates the noise values accordingly. The next step is to subtract the noise vectors from the received signal in the previously defined order until a codeword is obtained. The codeword received is identical to the one selected by the ML decoder. The problem with the GRAND decoder is the long time required to search for a codeword. For this reason, the maximum number of permitted attempts to find a codeword is limited. As soon as this number is reached, the algorithm stops.

There are different forms of the GRAND algorithm, which differ in the order in which the noise vectors are tested. For example, there is an algorithm for hard and soft demodulation and the algorithm is very parallelizable.

Examples of the present disclosure may universally solve the decoding problem, which can be broken down into two independent steps. First, a list generation algorithm is used to generate a list of codewords. In the second step, the ML decoder is applied to this generated list. This allows applying the ML decoder to a subset of the codebook, which limits the complexity.

Examples use an algorithm for generating a list of codewords, which is shown as pseudocode in algorithm 1 subsequently.

The inputs for the algorithm are the generator matrix G (used for encoding the original information bits into original codewords), the softly de-modulated channel output y (received codeword), the list size (queue limit) of the output L and the maximum number of queries max.query (determined by the limit value) and the order (maximum error order).

First, the algorithm begins with the initialization phase. Again, the example first sorts the soft demodulated channel output y in descending order of the likelihood of the individual bits ${y}^{˜} ′ : = {λ}_{1} \left(y\right)$ with $\left|{y}^{˜}′\left[1\right]\right| \geq \left|{y}^{˜}′\left[2\right]\right| \geq ⋯ \geq \left|{y}^{˜}′\left[N\right]\right| .$

This sorting generates a mapping λ₁, which is also applied to the columns of the generator matrix G $G ′ : = {λ}_{1} \left(G\right) .$

In this example, the generating 14 of the method 10 comprises determining the first mapping *λ*₁ as part of the systematic code mapping between the order of the received codeword y and a sorted received codeword *ỹ*'. The sorted received codeword *ỹ*' is sorted based on the soft values of the soft decoded bits. The method 10 further comprises applying the first mapping *λ*₁ to the generator matrix G of the code of the received codeword to obtain the mapped generator or reordered matrix G'.

Next, the reordered matrix G' is searched for K linearly independent columns, which also have the largest possible associated probability values |*ỹ'* [*i*]| with *i* ∈ {1,2, ... , *N*}. These K linearly independent columns are now the first K columns of a new generator matrix G" $G " : = {λ}_{2} \left(G′\right) ,$ where both these K columns and the remaining N-K columns are ordered in descending order of probability. This second mapping λ₂ is then applied in turn to *ỹ*' ${y}^{˜} : = {λ}_{2} \left({y}^{˜}′\right)$ with $\left|{y}^{˜}\left[1\right]\right| \geq \left|{y}^{˜}\left[2\right]\right| \geq ⋯ \geq \left|{y}^{˜}\left[K\right]\right| ,$ and $\left|{y}^{˜}\left[K+1\right]\right| \geq \left|{y}^{˜}\left[K+2\right]\right| \geq ⋯ \geq \left|{y}^{˜}\left[N\right]\right| .$

Hence the method 10 further comprises determining the second mapping *λ*₂ as part of the systematic code mapping. The second mapping *λ*₂ transforms the mapped generator matrix G' to a generator matrix G", which is then brought into a systematic form Gsys, wherein the determining of the second mapping *λ*₂ is based on the mapped generator matrix G'. The generating 14 comprises applying the first and second mappings *λ*₁, *λ*₂ to the received codeword to obtain the sorted codeword *ỹ*.

The following is a pseudo code of the algorithm for the list generation:

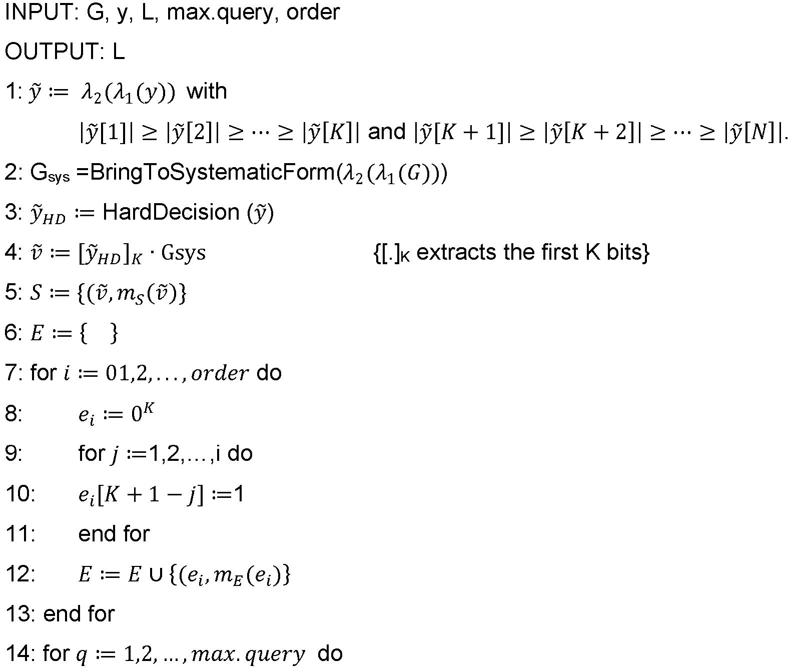

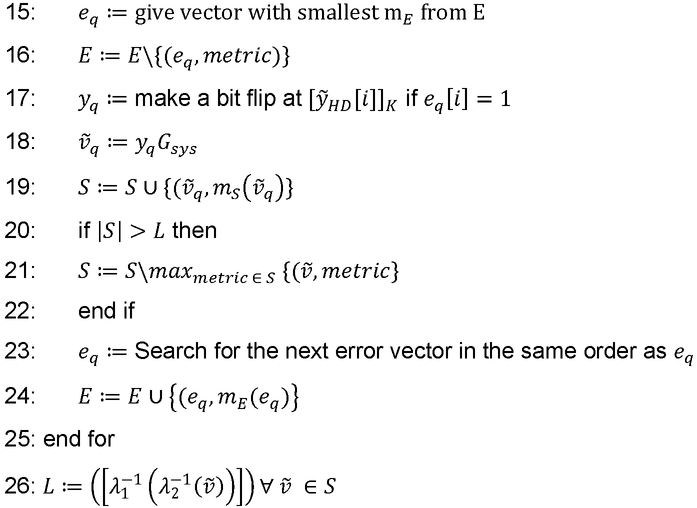

Note that |*ỹ*[*K*]| ≱ |*ỹ*[*K* + 1]| is possible.

After rearranging the generator matrix G with *λ*₁ and *λ*₂ to G" a systematic generator matrix can be generated with simple series operations. These steps are shown in the pseudo code in lines 1 and 2 and are similar to the OSD. Please note that the systematic generator matrix G_{sys} generated codeword with the inverse mappings ${λ}_{1}^{- 1}$ and ${λ}_{2}^{- 1}$ can be mapped to a codeword of the generator matrix G.

Next, the soft demodulated and restructured input *ỹ* his hard-demodulated. The first K bits are used in line 4 to generate a first codeword *ṽ*. This codeword is initially entered into the queue S with the associated metric *m_{S}*(*ṽ*)*,* which indicates the probability of this codeword and is directly proportional to the likelihoods. Two examples that can be taken here as metrics for *m_{S}*(*ṽ*) are given. On the one hand, the metric may correspond to the sum of the likelihoods of the bit positions that differ between the generated codeword and the hard demodulated one. A second possibility is to modulate the generated codeword and calculate the Euclidean distance to the channel output. In both examples, the smaller the metric, the higher the probability that this codeword was sent. Hence, the metric may correspond to a sum of the absolute soft values of the bits of the sorted codeword, which divert from the generated codeword, and/or the metric may correspond to a Euclidean distance of a modulated generated codeword and the received codeword.

In the example the decoding 16 of the method 10 comprises hard decoding the sorted codeword *ỹ* to obtain a hard-decoded codeword *ỹ_{HD}* and re-encoding the hard-decoded codeword *ỹ_{HD}* to obtain a generated codeword *ṽ.* The decoding 16 further comprises determining a metric *m_{S}*(*ṽ*) for the generated codeword *ṽ* indicating a likelihood of the generated codeword in view of the sorted codeword *ỹ*. The decoding further comprises storing the generated codeword *ṽ* together with the metric *m_{S}*(*ṽ*) as candidate codeword in the queue *S*.

In addition, the binary error vectors e are initialized in lines 6-13 and placed in a queue for error vectors. In examples, the decoding 16 may further comprise defining a set *E* of multiple error vectors e. An error vector e comprises one or more error digits based on the maximum error order and the set *E* of error vectors e comprises an error vector of each order from 1 to the maximum order. For example, an error vector of a specific order is determined by iterating through error vectors of the specific order. The number of error vectors may be limited by the limit value (through max.query, which may be the limit value increased by one) and a likeliness of an error vector may be determined based on the soft values of the sorted codeword at the error positions.

More specifically, the maximum error order given as input specifies the number of error vectors that are given in *E*. Depending on its own order, each error vector e has a number of components with the value 1. These are initialized at the bit positions, where the lowest values are initially at *ỹ*[*K*]*.* A metric *m_{E}* is also added to the queue to serve as an indicator for the order of the error vectors. After the initialization phase, a for-loop (lines14-25) is repeated until the maximum number of inputs max.query has been reached. In each iteration, the error vector with the lowest metric *m_{E}* is output (line 15) and removed (line 16). Bit flips are then performed at *ỹ_{HD}* at the bit positions where the error vector has a one (line 17). A new codeword is then generated and entered into the queue *S* with the corresponding metric *m_{S}* (lines18-19).

The iterating through the error vectors e may comprise systematically iterating through error positions in the error vector of the specific order. In some examples the systematically iterating may start at the most likely error position (e.g. at position K) and may end at the most unlikely error positions (e.g. at position 1). As outlined above the method 10 may further comprise assigning the error metric *m_{E}* to each of the error vectors e. The metric is based on the sorted codeword, e.g. based on the sum of absolute soft values of the sorted codeword at the error positions indicated by the ones in the respective error vector.

The decoding 16 further comprises, when iterating through the error vectors e, flipping bits in the hard-decoded codeword at positions at which the corresponding error vector indicates an error in the hard-decoded codeword *ỹ_{HD}* to obtain anew codeword candidate. The decoding further comprises re-encoding the new codeword candidate to obtain a generated candidate codeword and determining a metric *m_{S}* for the candidate codeword. Again, the metrics *m_{S}*, *m_{E}* may correspond to a sum of the absolute soft values of the bits of the sorted codeword, which divert from the generated candidate codeword and/or to an Euclidean distance of a modulated generated candidate codeword and the received codeword. The method 10 further comprises storing the error-corrected codewords or the generated candidate codewords together with the metrics in the queue *S*.

If *S* exceeds the maximum size L, the codeword with the largest metric *m_{S}* is removed in line 21. Hence, the method 10 further comprises obtaining a queue limit L and limiting the size of the queue *S* based on the queue limit L. If the queue *S* reaches the queue limit L a most unlikely candidate codeword is removed from the queue *S*.

An error vector is generated at the end of each iteration. This error vector has the same order as the error vector that was used to generate the codeword in this iteration. The new error vector can be generated by simply incrementing it, or by searching for the n-th error vector with the corresponding order, which has the lowest metric *m_{E}* in the first K bits of *ỹ_{HD}* (line 23). The generated error vector is then returned to the queue (line 24). Finally, all codewords are removed from the queue and using the inverse mappings ${λ}_{1}^{- 1}$ and ${λ}_{2}^{- 1}$ they are mapped into the space of the generator matrix G and displayed in a list (line 26). The decoding 16 hence comprises inversely mapping the codewords of the queue based on the systematic code mapping to obtain a queue of de-mapped codewords.

After the list has been generated using the example method 10, the codewords are now modulated. The ML decoder then iterates over the modulated list and decides on the most probable codeword. The decoding 16 then comprises modulating the de-mapped codewords of the queue to obtain a queue of modulated codewords and using maximum likelihood decoding of the modulated de-mapped codewords of the queue to obtain the most likely codeword candidate codeword.

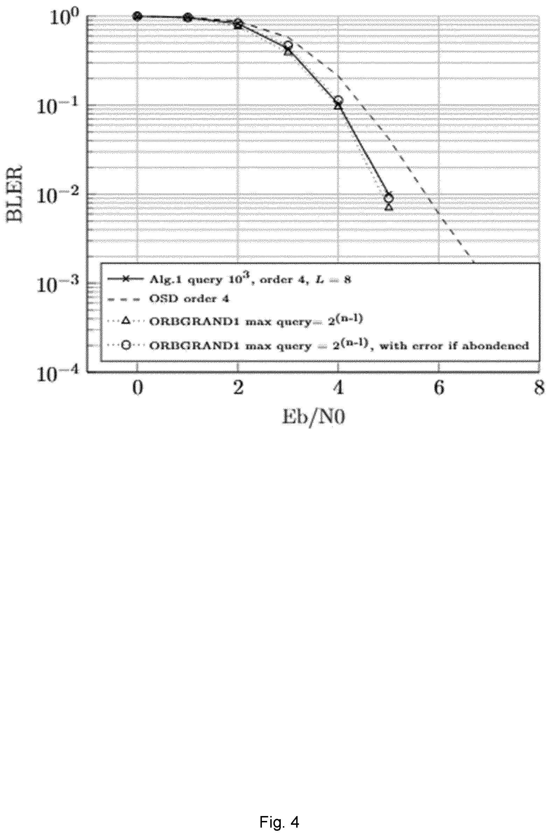

Fig. 4 shows a chart of BLER (Block Error Rate) versus Eb/NO (Bit energy/ Noise density) in a comparison of an example (Alg. 1), ORBGRAND (Ordered Reliability Bits GRAND) and OSD for a RLC (Random Linear Code) and N = 128, K = 116. The maximum error order for Alg. 1 and OSD was set to 4, the maximum list size is L=8. OSD also has a termination criterion, which is why it performs worse than Alg.1. Since simulations with an OSD decoder would take too long, it was decided to compare them with an OSD decoder, which also does not iterate through all possible error vectors. The implementation of [6] for the Soft OSD was used here.

The slightly worse ORBGRAND variant is the performance when abandoned before all iterations have been processed at the cost of an increased error. As can be seen from Fig. 4 the BLER performance of Alg. 1 is close to ORBGRAND and better than OSD with order 4.

Examples use the above algorithm for generating lists. Basically, examples are based on a similar principle as the OSD. In a way, examples can be seen as a parallelization of the OSD. As a result, faster error correction compared to an OSD of the same order can be obtained. The parallelization is to be understood in the consideration of error vectors of different orders in parallel. Although the error vector with the lowest metric is selected there always are error vectors of different orders in the set *E* under consideration.

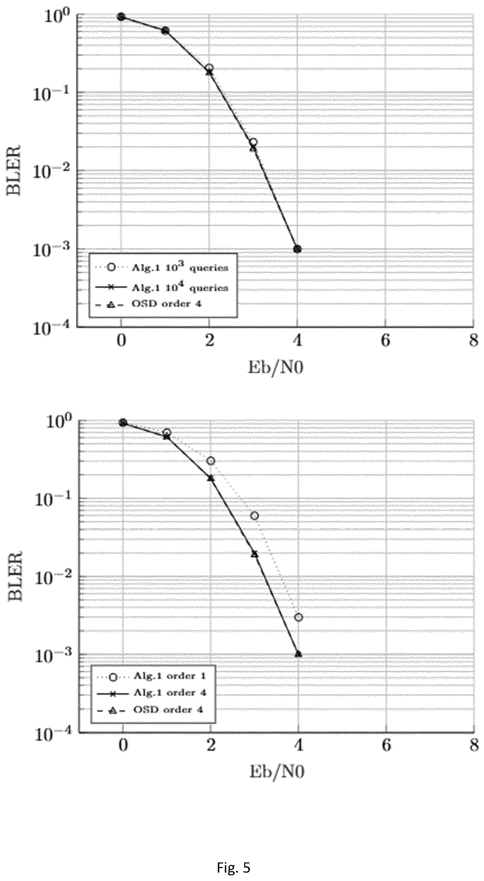

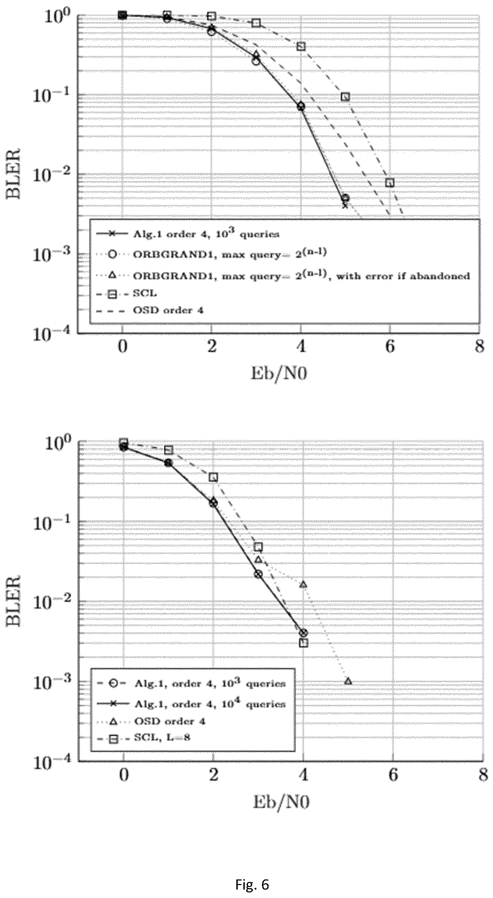

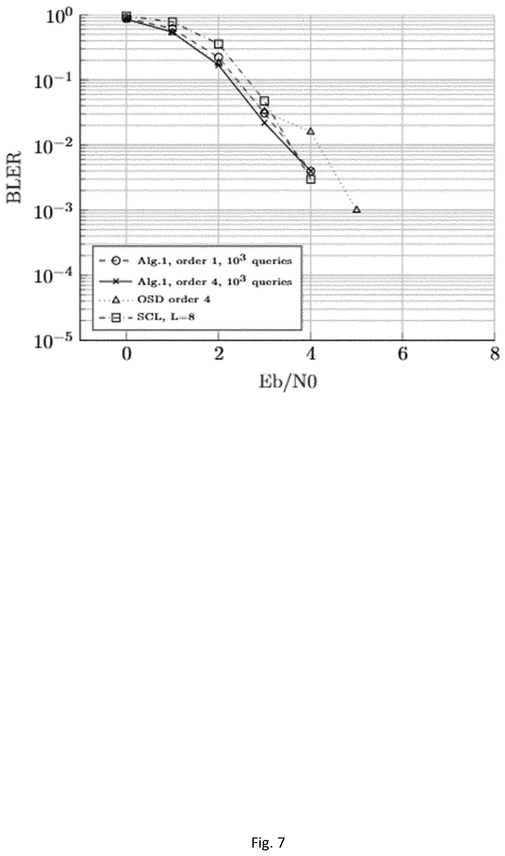

If one compares the performance of examples with a decoder from the GRAND family, the error correction at high rates of K is similar (always depends on the input variables of the decoder). This is illustrated in the following Figs. Fig. 5 illustrates a chart of BLER versus Eb/NO for different queries at the top and a chart of BLER versus Eb/NO for different orders at the bottom. At the top, a comparison with different queries for RLC and N = 128, K = 96 is given and it can be seen that the example algorithms for 10³ and 10⁴ queries performs similar to OSD with order 4. At the bottom a comparison with different orders for RLC and N = 128, K = 96 is shown. Again, the example with order 4 performs similar to OSD with order 4. The example with order 1 performs worse. Fig. 6 depicts a chart of BLER versus Eb/NO for different decoders at the top and a chart of BLER versus Eb/NO for different queries at the bottom. At the top a comparison with ORBGRAND and OSD for polar codes and N = 128, K = 116 is shown. The example performs similar to ORBGRAND and better than OSD. In addition, the performance an SCL (Successive Cancellation List) decoder is shown, which performs worse than the others. At the bottom a comparison with different queries for Polar Code and N = 128, K = 96 is shown. Again, the example algorithms (order 4, 10³ and 10⁴ queries) mostly outperform OSD and SCL. Fig. 7 shows a chart of BLER versus Eb/NO for different orders and decoders. A comparison with different orders for Polar Code and N = 128, k = 96 is shown. Again, the example algorithms (orders 1 and 4, 10³ queries) mostly outperform OSD and SCL.

The decoders from the GRAND family have disadvantages if low rates of K/N are used or if N-K is large enough. If this is the case, these decoders have a very large computational effort and sometimes abort the calculation prematurely, which is why they could not be simulated for parameters with N-K > 20.

If the example algorithm is compared with an OSD decoder, the example algorithm can at most have as good an error correction as an OSD decoder with the same order. The difference lies in the lower computing effort on the part of the example algorithm.

If the example algorithm is compared with Soft OSD, it can be seen that the example algorithm performs better than the Soft OSD at high rates and has an almost identical error rate at lower rates. Simulations with different orders are shown in Figs 5 (bottom) and Fig. 7 and different queries are shown in Fig. 5 (top) and Fig. 6 (bottom). As can be seen with both Polar Codes and RLC a lower error rate at higher order can be obtained. With a larger number of queries there are also fewer errors, the difference varies depending on the error-correcting code and can be very small.

It should be noted that example may represent a new way of reducing the complexity of the OSD decoder. At high rates it has a similar error correction as the decoders of the GRAND family and at low error correction a similar performance as the Soft OSD decoder with reduced complexity.

In the following a numerical example will be provided in line with the above pseudo code.

As an example to explain the pseudo code, the parameters n = 8, K = 5, L = 4, max.query= 4, order= 3,
are selected.

The generator matrix is given by $G = \left\{\begin{matrix}1 & 0 & 0 & 0 & 0 & 0 & 1 & 1 \\ 0 & 1 & 0 & 0 & 0 & 0 & 1 & 0 \\ 0 & 0 & 1 & 0 & 0 & 1 & 0 & 0 \\ 0 & 0 & 0 & 1 & 0 & 0 & 0 & 1 \\ 0 & 0 & 0 & 0 & 1 & 1 & 1 & 0\end{matrix}\right\} .$ (1)

A message *m* to be sent is a binary sequence of length K = 5. In the example, it is randomly selected with $m = \left(1 1 1 0 1\right) .$ (2)

The generator matrix is used to obtain the encoded message ${x}_{encoded} = m ⋅ G = \left(1 1 1 0 1 0 1 1\right)$ (3) which is modulated and sent over the channel. The noisy signal, which is received, is soft-demodulated. The soft demodulation gives the logarithmic probability of each individual bit of the transmitted message. The advantage over hard demodulation is that not only the binary decision is obtained, but also the probability information. An exemplary output of this soft demodulation would be $y = \left(0.057 -0.242 -0.016 -0.544 0.240 0.253 -0.513 0.556\right) .$ (4)

Given y, G, L = 4, max.query= 5, and order= 3 the pseudo code of algorithm 1 can be started as outlined above:
In line 1 the reordering *ỹ* := *λ*₂(*λ*₁(*y*)) with *λ*₁; and *λ*₂ takes place, so that the absolute probability values of the individual bits of *ỹ*[*i*] with *i* ∈ {1,2, *...* , *n*} are ordered as follows: $\left|{y}^{˜}\left[1\right]\right| \geq \left|{y}^{˜}\left[2\right]\right| \geq ⋯ \geq \left|{y}^{˜}\left[K\right]\right| ,$ (5) and $\left|{y}^{˜}\left[K+1\right]\right| \geq \left|{y}^{˜}\left[K+2\right]\right| \geq ⋯ \geq \left|{y}^{˜}\left[N\right]\right| .$ (6)

Note that |*ỹ*[*K*]| ≱ |*ỹ*[*K* + 1]| is possible. The reason for this lies in the second re-sorting *λ*₂, whereby the aim is to bring the generator matrix after the re-sorting *λ*₁ to a systematic form G_{sys} =BringToSystematicForm(*λ*₂(*λ*₁(*G*))) (line 2). In the example, *λ*₁ and *λ*₂ assign the resulting *ỹ* and G_{sys} as follows: ${y}^{˜} = \left(0.556 -0.544 -0.513 0.253 -0.242 0.240 0.057 -0.016\right)$ (7) ${G}_{sys} = \left\{\begin{matrix}1 & 0 & 0 & 0 & 0 & 1 & 1 & 1 \\ 0 & 1 & 0 & 0 & 0 & 1 & 1 & 1 \\ 0 & 0 & 1 & 0 & 0 & 1 & 0 & 1 \\ 0 & 0 & 0 & 1 & 0 & 0 & 0 & 1 \\ 0 & 0 & 0 & 0 & 1 & 1 & 0 & 1\end{matrix}\right\} .$ (8)

Note that *G_{sys}* ≠ G, although the original generator matrix G was already in systematic form. The reason for this is that *ỹ* ≠ *y* and therefore there is a reordering *λ*₁ in *G*, which means that G loses its systematic form. In line 3, the hard demodulation of *ỹ* is generated by setting *ỹ_{HD}*[*i*] = 1 if *ỹ* < 0 and *ỹ_{HD}*[*i*] = 0 if *ỹ* > 0 for *i* ∈ {1,2, ... , *n*}*.*

In the example, this results in ${{y}^{˜}}_{HD} = \left(0 1 1 0 1 0 0 1\right) .$ (9)

In line 4, the initial codeword *ṽ* for the queue S is generated from the first K = 5 bits of *ỹ_{HD}*: ${v}^{˜} = \left(0 1 1 0 1\right) ⋅ {G}_{sys} = \left(0 1 1 0 1 1 1 1\right)$ (10) with the metric *m_{S}*(*ṽ*) = 0.297, which is the sum of all |*ỹ*[*i*]|, for which *ỹ_{HD}*[*i*] ≠ *ṽ*[*i*] hence ${m}_{S} \left({v}^{˜}\right) = {\sum }_{i : {v}^{˜} \left[i\right] \neq {{y}^{˜}}_{HD} \left[i\right]} \left|{y}^{˜}\left[i\right]\right| .$

In line 5 the queue *S* = { *ṽ*; 0.297} with *ṽ* from equation 10 and *m_{S}*(*ṽ*) = 0.297 is initialized.

The error queue E is initialized in lines 6-13 with the error vectors *eᵢ* with the associated metrics *m_{E}*(*eᵢ*)*.* Each error vector *eᵢ* has the length K, corresponds to the order *i* ∈ {1,2, ... , *order*} and consists of zeros except at the trailing *i* bit positions. The metric *m_{E}*(*eᵢ*) is the sum of all |*ỹ*[*i*]| for all bit position for which *eᵢ*[*j*] = 1, hence ${m}_{E} \left({e}_{i}\right) = {\sum }_{j : {e}_{i} \left[j\right] = 1} \left|{y}^{˜}\left[i\right]\right| .$

In the example order= 3 is selected hence there are three error vectors in this queue $\begin{matrix}E = \left\{\left(\left(0 0 0 0 1\right); 0.242\right)\right\} , & \left(11\right) \\ \left\{\left(\left(0 0 0 1 1\right); 0.495\right)\right\} , & \left(12\right) \\ \left\{\left(\left(0 0 1 1 1\right); 1.008\right)\right\} . & \left(13\right)\end{matrix}$

After this initialization phase, the for-loop in line 14 is run a total of_five times because max.query= 5 is selected for the example. In each iteration, the error vector with the lowest metric *m_{E}* is extracted from *E* (lines 15 and 16). This yields for q = 1 ${e}_{1} = \left(0 0 0 0 1\right)$ (14) and $\begin{matrix}E = \left\{\left(\left(0 0 0 1 1\right); 0.495\right)\right\} , & \left(15\right) \\ \left\{\left(\left(0 0 1 1 1\right); 1.008\right)\right\} . & \left(16\right)\end{matrix}$ after line 16. Next, *y₁* is replaced by ${y}_{1} = {\left[{{y}^{˜}}_{HD}\right]}_{K} ⊕ {e}_{1} = \left(0 1 1 0 0\right)$ (17) and ${{v}^{˜}}_{1} = {y}_{1} ⋅ {G}_{sys} = \left(0 1 1 0 0 0 1 0\right)$ (18) is generated with the metric *m_{S}*(*ṽ*) = 0.315 and entered in queue *S* in line 19. Since the maximum list size L = 4 > 2, lines 20 - 23 are not used in the first iteration. Finally, the next error vector *e₁* is searched for, which has the same order as the error vector in line 15. The aim is for the next error vector to have the smallest metric *m_{E}*(*eᵢ*) among the remaining error vectors of the same order. In the first order the bit position of the one is reduced by one. In the second order, the position of the one, which has a higher bit position, is reduced until it is directly behind the bit position of the one with a lower bit position. In this case, the one with a higher bit position is set to its initial bit position (bit position K) and the bit position of the one with a lower bit position is reduced by one. For higher orders, this procedure is extended accordingly for each one. The one moves forward from the bit position until it reaches the bit position of the next one. It is then set back to its corresponding starting position (starting position is e.g. K, K-1, ...) and the one with a smaller bit position is moved forward by one bit position. The third-order error vector would change as follows: $\begin{matrix}\left(0 0 1 1 1\right) \to \left(0 1 0 1 1\right) \to \left(0 1 1 0 1\right) \to & \left(19\right) \\ \left(0 1 1 1 0\right) \to \left(1 0 0 1 1\right) \to \left(1 0 1 0 1\right) \to & \left(20\right) \\ \left(1 0 1 1 0\right) \to \left(1 1 0 0 1\right) \to \left(1 1 0 1 0\right) \to & \left(21\right) \\ \left(1 1 1 0 0\right) & \left(22\right)\end{matrix}$

In the case of the first iteration, there is a first-order error vector and the error vector that is looked for in line 23 is ${e}_{1} = \left(0 0 0 1 0\right)$ (23) whereby the queues S and E look as follows after the first iteration through the for-loop from lines 14 - 25 : $\begin{matrix}S = \left\{\left(\left(0 1 1 0 1 1 1 1\right); 0.297\right)\right\} , & \left(24\right) \\ \left\{\left(\left(0 1 1 0 0 0 1 0\right); 0.315\right)\right\} . & \left(25\right)\end{matrix}$ $\begin{matrix}E = \left\{\left(\left(0 0 0 1 0\right); 0.253\right)\right\} , & \left(26\right) \\ \left\{\left(\left(0 0 0 1 1\right); 0.495\right)\right\} , & \left(27\right) \\ \left\{\left(\left(0 0 1 1 1\right); 1.008\right)\right\} . & \left(28\right)\end{matrix}$

Note that for the error vector in lines 15 and 16, the error vector with the lowest metric *m_{E}* is always used. This results in an error vector of a higher order but lower metric being taken before an error vector with a lower order. In the following, S and E will be specified after line 24 for each iteration of the for-loop: q=2: $S = \begin{matrix}\left\{\left(\left(0 1 1 0 1 1 1 1\right); 0.297\right)\right\} , & \left(29\right) \\ \left\{\left(\left(0 1 1 0 0 0 1 0\right); 0.315\right)\right\} , & \left(30\right) \\ \left\{\left(\left(0 1 1 1 1 1 1 0\right); 0.566\right)\right\} , & \left(31\right)\end{matrix}$ $\begin{matrix}E = \left\{\left(\left(0 0 0 1 1\right); 0.495\right)\right\} , & \left(32\right) \\ \left\{\left(\left(0 0 1 0 0\right); 0.513\right)\right\} , & \left(33\right) \\ \left\{\left(\left(0 0 1 1 1\right); 1.008\right)\right\} . & \left(34\right)\end{matrix}$ q=3: $\begin{matrix}S = \left\{\left(\left(0 1 1 0 1 1 1 1\right); 0.297\right)\right\} , & \left(35\right) \\ \left\{\left(\left(0 1 1 0 0 0 1 0\right); 0.315\right)\right\} , & \left(36\right) \\ \left\{\left(\left(0 1 1 1 0 0 1 1\right); 0.552\right)\right\} , & \left(37\right) \\ \left\{\left(\left(0 1 1 1 1 1 1 0\right); 0.566\right)\right\} , & \left(38\right)\end{matrix}$ $\begin{matrix}E = \left\{\left(\left(0 0 1 0 0\right); 0.513\right)\right\} , & \left(39\right) \\ \left\{\left(\left(0 0 1 0 1\right); 0.755\right)\right\} , & \left(40\right) \\ \left\{\left(\left(0 0 1 1 1\right); 1.008\right)\right\} . & \left(41\right)\end{matrix}$ q=4: $\begin{matrix}S = \left\{\left(\left(0 1 1 0 1 1 1 1\right); 0.297\right)\right\} , & \left(42\right) \\ \left\{\left(\left(0 1 1 0 0 0 1 0\right); 0.315\right)\right\} , & \left(43\right) \\ \left\{\left(\left(0 1 1 1 0 0 1 1\right); 0.552\right)\right\} , & \left(44\right) \\ \left\{\left(\left(0 1 1 1 1 1 1 0\right); 0.566\right)\right\} , & \left(45\right)\end{matrix}$ $\begin{matrix}E = \left\{\left(\left(0 1 0 0 0\right); 0.544\right)\right\} , & \left(46\right) \\ \left\{\left(\left(0 0 1 0 1\right); 0.755\right)\right\} , & \left(47\right) \\ \left\{\left(\left(0 0 1 1 1\right); 1.008\right)\right\} . & \left(48\right)\end{matrix}$

Note that S is identical for q =3 and q=4, because the generated *ṽ* = (0 1 0 0 1 0 1 0) with metric *m_{S}=0.586* is removed from the queue S again because all other codewords the list have a smaller metric. If there are more than L codewords in the queue S in line 20, the codeword with the largest metric *m_{S}* is removed from the queue, which means that there are L codewords in the list again. After the for-loop in lines 14-25 has been run a total of max.query times, the codewords contained in L are re-mapped in line 26 with the help of ${λ}_{1}^{- 1}$ and ${λ}_{2}^{- 1}$, so that the resulting list L only contains codewords from the generator matrix *G*.

In the following use of the example algorithm with and without ML decoding will be detailed. The algorithm can be applied in two ways in examples: A first example is a stand-alone decoder. If used as standalone decoder, list size L = 1 can be selected, which means that the most probable codeword from the algorithm is output. However, there are also scenarios in which, for example, not all codewords are valid or in which a list of codewords is required and the codewords contained must be processed further. In these cases, the list size can be set as required and the algorithm can be used as a list generation algorithm. After creating the list, for example, all non-valid codewords may be removed from the list and further operations on the remaining codewords from the list may be performed so that new list L' can be obtained. For example, a maximum likelihood decoder is then applied to the further processed codewords from the list L' ${p}_{CW} \left(z\left|L′\right.\right) = \begin{matrix}max \\ x ∈ L ′\end{matrix} {\prod }_{i = 1}^{c} w \left({z}_{i}\left|{x}_{i}\right.\right) ,$ (49) which decides on the most probable codeword z from the list L' of codewords provided to it. c is the symbol length, which is the block length n divided by the number of bits per symbol (which depends on the modulation). The expression *w*(*zᵢ*|*xᵢ*) indicates the probability density for the *i^{th}* channel usage. For AWGN (Additive White Gaussian Noise) channels, this can be done with $w \left({z}_{i}\left|{x}_{i}\right.\right) = \frac{SNR}{π} exp \left(-{\left|{z}_{i}-{x}_{i}\right|}^{2}SNR\right) ,$ where SNR is the estimated signal-to-noise ratio.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, -functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A method (10) for decoding a received codeword, which is based on an encoded original codeword, the method (10) comprising
obtaining (12) the received codeword as soft decoded bits, a maximum error order and a limit value;
generating (14) a queue of codeword candidates, the codeword candidates are based on the maximum error order, the limit and a sorted codeword, which is based on the received codeword, wherein the sorted codeword comprises sorted soft decoded bits, which are sorted based on their soft values and based on a systematic code mapping;
decoding (16) the codeword candidates of the queue to determine a most likely codeword candidate; and
selecting (18) the most likely codeword candidate as decoded original codeword.

2. The method (10) of claim 1, wherein the generating (14) further comprises determining a first mapping as part of the systematic code mapping between the order of the received codeword and a sorted received codeword, the sorted received codeword being sorted based on the soft values of the soft decoded bits, and further applying the first mapping to a generator matrix of a code of the received codeword to obtain a mapped generator matrix.

3. The method (10) of claim 2, further comprising determining a second mapping as part of the systematic code mapping, the second mapping transforming the mapped generator matrix to a systematic generator matrix, wherein the determining of the second mapping is based on the mapped generator matrix, wherein the generating comprises applying the first and second mappings to the received codeword to obtain the sorted codeword.

4. The method (10) of one of the claims 1 to 3, wherein the decoding (16) comprises hard decoding the sorted codeword to obtain a hard-decoded codeword,
re-encoding the hard-decoded codeword to obtain a generated codeword,
determining a metric for the generated codeword indicating a likelihood of the generated codeword in view of the sorted codeword, and
storing the generated codeword together with the metric as candidate codeword in the queue.

5. The method (10) of claim 4, wherein the decoding (16) further comprises defining a set of multiple error vectors,
wherein an error vector comprises one or more error digits based on the maximum error order and wherein the set of error vectors comprises an error vector of each order from 1 to the maximum order, wherein an error vector of a specific order is determined by iterating through error vectors of the specific order, wherein the number of error vectors is limited by the limit value and wherein a likeliness of an error vector is determined based on the soft values of the sorted codeword at the error positions.

6. The method (10) of claim 5, wherein the iterating comprises systematically iterating through error positions in the error vector of the specific order.

7. The method (10) of one of the claims 5 or 6, further comprising assigning an error metric to each of the error vectors, wherein the metric is based on the sorted codeword.

8. The method (10) of one of the claims 4 to 7, wherein the decoding (16) comprises, when iterating through the error vectors, flipping bits in the hard-decoded codeword at positions at which the corresponding error vector indicates an error in the hard-decoded codeword to obtain a new codeword candidate, re-encoding the new codeword candidate to obtain a generated candidate codeword, and determining a metric for the candidate codeword.

9. The method (10) of one of the claims 4 to 8, wherein the metric corresponds to a sum of the absolute soft values of the bits of the sorted codeword, which divert from the generated candidate codeword, and/or wherein the metric corresponds to an Euclidean distance of a modulated generated candidate codeword and the received codeword.

10. The method (10) of one of the claims 8 or 9, further comprising storing the error-corrected codewords or the generated candidate codewords together with the metrics in the queue.

11. The method (10) of claim 10, wherein the decoding (16) further comprises inversely mapping the codewords of the queue based on the systematic code mapping to obtain a queue of de-mapped codewords.

12. The method (10) of claim 11, wherein the decoding (16) further comprises modulating the de-mapped codewords of the queue to obtain a queue of modulated codewords and using maximum likelihood decoding of the modulated de-mapped codewords of the queue to obtain the most likely codeword candidate codeword.

13. The method (10) of one of the claims 1 to 12, further comprising obtaining a queue limit and limiting the size of the queue based on the queue limit, wherein if the queue reaches the queue limit a most unlikely candidate codeword is removed from the queue.

14. A computer program having a program code for performing one of the methods (10) of one of the claims 1 to 13, when the computer program is executed on a computer, a processor, or a programmable hardware component.

15. An apparatus (20) for decoding a received codeword, which is based on an encoded original codeword, the apparatus (20) comprising
one or more interfaces (22) configured to communicate in a decoding system; and
one or more processing devices (24) configured to perform one of the methods (10) of one of the claims 1 to 13.
